# EUROPÄISCHE PATENTSCHRIFT

(11) **EP 2 438 396 B1**
(45) Veröffentlichungstag und Bekanntmachung des Hinweises auf die Patenterteilung: **13.04.2016**
(21) Anmeldenummer: 11704475.0
(22) Anmeldetag: 10.01.2011
(51) Int. Cl.: G01B 11/06, H01L 21/00

(54) **DÜNNUNGSVORRICHTUNG MIT EINER NASSÄTZEINRICHTUNG UND EINER ÜBERWACHUNGSVORRICHTUNG**
THINNING DEVICE COMPRISING A WET ETCHING UNIT AND A MONITORING DEVICE
DISPOSITIF D'AMINCISSEMENT AVEC UN DISPOSITIF D'ATTAQUE CHIMIQUE HUMIDE ET UN DISPOSITIF DE SURVEILLANCE

(30) Priorität: 12.03.2010 DE 102010015944; 14.01.2010 DE 102010000079
(43) Veröffentlichungstag der Anmeldung: 11.04.2012
(73) Patentinhaber: Precitec Optronik GmbH, 63110 Rodgau (DE); Dusemund Pte. Ltd., Singapur 609916 (SG)
(72) Erfinder: DUSEMUND, Claus, Singapur 609916 (SG); SCHÖNLEBER, Martin, 63743 Aschaffenburg (DE); MICHELT, Berthold, 65195 Wiesbaden (DE); DIETZ, Christoph, 63179 Obertshausen (DE)
(74) Vertreter: Schweiger, Martin
(86) Internationale Anmeldenummer: PCT/IB2011/050091
(87) Internationale Veröffentlichungsnummer: WO 2011/086490

(56) Entgegenhaltungen:
- WO-A2-2006/127952
- DE-A1-102005 006 724
- US-A- 5 905 572
- US-A1- 2003 090 671
- US-A1- 2006 158 659
- US-A1- 2007 086 013
- US-A1- 2007 231 717
- US-A1- 2007 249 071
- US-A1- 2007 258 095
- US-A1- 2008 049 233
- US-A1- 2009 257 065

## Beschreibung

Die Erfindung betrifft und ein Verfahren für ein in-situ Messen von Waferdicken beim Dünnen von Halbleiterwafern sowie eine Dünnungsvorrichtung mit einer Überwachungsvorrichtung. Die Dünnungsvorrichtung weist dazu eine Einrichtung zum Dünnen mindestens eines Halbleiterwafers auf mit einer Steuereinheit für ein Steuern einer aufzubringenden Menge von Ätz- oder Spülflüssigkeiten und für ein Steuern einer Drehzahl einer rotierenden Haltevorrichtung, auf welcher der Halbleiterwafer angeordnet ist. Außerdem weist die Dünnungsvorrichtung eine Messeinrichtung zum Messen der Dicke des sich drehenden Halbleiterwafers mit einem kontaktfreien Messkopf und einer Lichtquelle mit kohärenter Lichtemission im nahen Infrarotbereich auf.

Eine Dickenmessvorrichtung und ein entsprechendes Dickenmessverfahren sowie eine Nassätzvorrichtung und eine Nassätzmethode unter Verwendung der Messvorrichtung und des Messverfahrens sind aus der Druckschrift US 6,897,964 B2 bekannt. Die bekannte Messvorrichtung gemäß diesem Stand der Technik zeigt Figur 2 mit einer Messvorrichtung 12 und einer Ätzvorrichtung. Die bekannte Ätzvorrichtung weist eine Einrichtung 5' zum Dünnen mindestens eines Halbleiterwafers 4 auf. Diese Einrichtung 5' verfügt über eine drehbare Haltevorrichtung 6 für den zu dünnenden Halbleiterwafer 4, der gestützt durch ein Substrat 32 auf einem Drehteller 21 angeordnet ist. Der Drehteller 21 wird von einem Motor 19 mit einer Drehzahl n angetrieben, die durch eine Steuereinheit 11 gesteuert wird. Über einen Spender 7 werden Ätzflüssigkeiten 8 und/oder Spülflüssigkeiten 9 zu einer Düse 50 geleitet, die eine zu ätzende Oberfläche 10 des zu dünnenden Halbleiterwafers 4 mit einem Ätzfilm 22 benetzt.

Während des Dünnens des Halbleiterwafers 4 misst eine Messvorrichtung 12' mittels eines Messkopfes 13 nacheinander, in zeitlichen Abständen die Dicke des zu dünnenden Halbleiterwafers 4 aufgrund des Zeitunterschieds zwischen dem Anteil der Strahlung, die auf der zu ätzenden Oberfläche 10 von dem Halbleiterwafer 4 reflektiert wird, und dem Teil, der nach Durchdringen des Halbleiterwafers von einer gegenüberliegenden Oberfläche 48 des Halbleiterwafers 4 reflektiert wird. Dazu wird über Lichtwellenleiter 24 und 26 sequenziell kohärentes Licht des nahen Infrarotbereichs von einer Lichtquelle 14 zu dem Messkopf 13 und auf den Halbleiterwafer 4 gerichtet, wobei zwischen den beiden Lichtwellenleitern 24 und 26 ein optischer Koppler 27 angeordnet ist, der das Licht der Lichtquelle 14 einerseits dem Messkopf 13 und andererseits über einen optischen Referenzlichtwellenleiter 47 einer Referenzlichterzeugung 44 zuführt.

Diese Referenzlichterzeugung 44 ist für diese Art der Vorrichtung aus dem Stand der Technik entscheidend, um den Laufzeitunterschied zwischen der Reflektion der beiden Oberflächen 10 und 48 des Halbleiterwafers 4 periodisch in Zeitabständen zu ermitteln. Dazu weist die Referenzlichterzeugung 44 ein Spiegelgalvanometer 37 auf, das mit einem schwenkbaren Parallelplattenglassubstrat 38 zusammenwirkt und mit Hilfe eines Reflektorspiegels 39 einen optischen Referenzpfad 46 bildet, der über den optischen Referenzlichtwellenleiter 47 und den optischen Koppler 27 das optische Referenzsignal über einen Lichtwellenleiter 25 einem Photodetektor 45 zuführt, während gleichzeitig das Spiegelgalvanometer 37 über eine optische Referenzpfaderfassung 40 die Laufzeitdifferenz zwischen den beiden reflektierten Strahlanteilen zwischen Oberfläche 10 und Oberfläche 48 des Halbleiterwafers 4 an eine Auswerteeinheit 18 liefert. Die Auswerteeinheit 18 empfängt zusätzlich die Messsignale des Photodetektors 45 und erfasst periodisch eine Rohdicke in einer ersten Signalverarbeitungsschaltung 41 in Zusammenwirken mit einer Rohdickenberechnungseinrichtung 42, und ermittelt aufgrund der hohen Streuung der Rohdickenberechnungen in einem weiteren Berechnungsblock 43 der Auswerteeinheit 18 aus den Rohwerten eine statistische Dickenberechnung 43.

Die bekannte Vorrichtung 2 für ein Messen von Waferdicken während des Dünnens von Halbleiterwafer 4 hat somit den Nachteil, dass die Dickenmessung von einem Spiegelgalvanometer 37 abhängig ist, das aufgrund der Schwenkbewegungen des Glassubstrats 38 eine kontinuierliche Erfassung einer Waferdicke 3 nicht ermöglicht. Es kann lediglich sequenziell in Zeitabständen eine Rohdickenberechnung durchgeführt werden. Hinzu kommt, dass mit dieser bekannten Vorrichtung 2 die berechneten Rohdicken derart streuen, dass zusätzlich nach einer endlichen Anzahl von Rohdickenmessungen eine statistische Dickenberechnung erforderlich wird, um den wahrscheinlichsten Verlauf der Dickenabnahme zu ermitteln.

Durch den erforderlichen Referenzarm, der an den optischen Koppler 27 anzuschließen ist und der mit der Auswerteeinheit 18 in Verbindung steht, um die Messwerte des Photodetektors 45 den beiden Oberflächen 10 und 48 des Halbleiterwafers 4 zuzuordnen, wird eine Vorrichtung gebildet, die erschütterungsempfindlich durch das Spiegelgalvanometer 37 und relativ unzuverlässig aufgrund der Streuung der periodisch ermittelten Rohdickenwerte ist. Darüber hinaus ist mit diesem Verfahren eine kontinuierliche Erfassung der Abnahme der Waferdicke 3 während des Dünnens des Halbleiterwafers 4 nicht möglich, da nur eine begrenzte Zahl an Rohdickenwerten während einer Umdrehung des Halbleiterwafers 4 auf der drehbaren Haltevorrichtung 6 möglich ist.

Aus der US 2007/0258095 A1 sind eine Vorrichtung und ein Verfahren zur hochauflösenden Netzhaut-Bildgebung mittels optischer Kohärenztomographie bekannt.

Aus der US 2009/257065 A1 ist ein chirurgisches Mikroskopsystem bekannt, das eine optische Kohärenztomographie-Einrichtung aufweist.

Aus der US 2007/231717 A1 ist ein Verfahren zur dynamischen Erfassung vielfach strukturierter Schichten auf einem Substrat mittels optischer Kohärenztomographie bekannt. Aus der US 5905572 A ist eine Untersuchungseinrichtung zum Untersuchen einer Probe, beispielsweise eines Wafer, mittels optischer Kohärenztomographie bekannt.

Aus der US 2007/0249071 sind eine Vorrichtung und ein Verfahren zum Überwachen eines Subratsverarbeitungsprozesses mittels elektromagnetischer Strahlung bekannt. Aus d

er WO 2006/127952 A2 sind eine Vorrichtung und ein Verfahren zur.Vollphasen-Interferometrie bekannt.

Aus der US 2008/0049233 A1 sind eine Vorrichtung und ein Verfahren zum Scannen der Oberflächentopographie eines Halbleiterwafers mittels Auswertung von Interferometersignalen bekannt.

Aus der US 2007/0086013 A1 sind ein Verfahren und ein System zur Untersuchung einer Waferoberfläche mittels eines Interferometers bekannt. Aus der US 2006/0158659 A1 ist ein Interferometer zum Bestimmen einer Charakteristik einer Oberfläche eines Objekts, wie beispielsweise eines beschichteten Wafers, bekannt.

Aus der DE 10 2005 006 724 A1 sind ein Verfahren und eine Anordnung zur optischen Kohärenztomographie bei biologischen und technischen Objekten bekannt.

Aufgabe der Erfindung ist es, ein neues Verfahren für ein Messen von Waferdicken beim Dünnen von Halbleiterwafern zum Überwachen eines Dünnens mindestens eines Halbleiterwafers sowie eine Dünnungsvorrichtung mit einer Überwachungsvorrichtung zu schaffen, die die Nachteile der bekannten Vorrichtung und des bekannten Verfahrens überwinden und die Robustheit und Zuverlässigkeit der Dickenmessung beim Dünnen von Halbleiterwafern verbessern.

Gelöst wird diese Aufgabe mit dem Gegenstand der unabhängigen Ansprüche. Vorteilhafte Weiterbildungen der Erfindung ergeben sich aus den abhängigen Ansprüchen.

Eine Überwachungsvorrichtung zum Überwachen eines Dünnens mindestens eines Halbleiterwafers in einer Nassätzeinrichtung wird geschaffen, wobei die Überwachungsvorrichtung eine Lichtquelle, ausgebildet zum Emittieren kohärenten Lichts eines Lichtwellenbandes, für das der Halbleiterwafer optisch transparent ist, aufweist. Weiterhin weist die Überwachungsvorrichtung einen kon- taktfrei zu einer zu ätzenden Oberfläche des Halbleiterwafers angeordneten Messkopf auf, wobei der Messkopf zum Bestrahlen des Halbleiterwafers mit dem kohärenten Licht des Lichtwellenbandes und zum Empfangen einer von dem Halbleiterwafer reflektierten Strahlung ausgebildet ist. Darüber hinaus weist die Überwachungsvor- richtung ein Spektrometer und einen Strahlteiler, über den das kohärente Licht des Lichtwellenbandes auf den Messkopf und die reflektierte Strahlung auf das Spektrometer gelenkt wird, auf. Des weiteren weist die Überwachungsvorrichtung eine Auswerteeinheit auf, wobei die Auswerteeinheit zum Ermitteln einer Dicke d(t) des Halbleiterwafers aus der von dem Halbleiterwafer reflektierten Strahlung während.des Dünnens des Halbleiterwafers mittels eines Verfahrens, ausgewählt aus der Gruppe, bestehend aus einem ID-se FDOCT-Verfahren (eindimensionales räumlich kodiertes Fourier Domain Optical Coherence Tomography-Verfahren), einem ID-te FDOCT-Verfahren (eindimensionales zeitlich kodiertes Fourier Domain Optical Coherence Tomography-Verfahren) und einem ID-se TDOCT-Verfahren (eindimensionales räumlich kodiertes Time Domain Optical Coherence Tomography-Verfahren), ausgebildet ist.

Diese Überwachungsvorrichtung hat den Vorteil, dass die Erfassung der Waferdicke nicht von einer bewegbaren oder schwenkbaren Referenzlichtapparatur abhängig ist, sondern die Überwachungsvorrichtung dazu im Falle des ID-se FDOCT-Verfahrens und des 1D-te FDOCT-Verfahrens ein statisches Spektrometer sowie im Falle des ID-se TDOCT-Verfahrens ein statisches Fourierspektrometer, mit dem durch numerische Fouriertransformation ein Spektrum berechenbar ist, aufweist. Diese makromechanisch unbeweglichen Komponenten ermöglichen eine Auswertung in einer Auswerteeinheit, bei der die Anzahl pro Umdrehung der ausgewerteten Waferdicke lediglich von der Rechengeschwindigkeit und Rechenkapazität der an das Spektrometer angeschlossenen Auswerteeinheit abhängig ist. Zudem hat die Überwachungsvorrichtung den Vorteil, dass kein Referenzarm vorzusehen ist.

Lediglich im Falle des 1D-te FDOCT-Verfahrens ist als Lichtquelle ein zeitlich durchstimmbarer Laser erforderlich, der mit einer schwingenden Mikromechanik zur 'Durchstimmung des Lasers arbeitet. Jedoch liegt die Schwingung der Mikromechanik und damit die Messrate mit 400 kHz um mehr als zwei Größenordnungen höher als bei dem bekannten Galvanometer.

Bei der Fouriertransformation werden die von den beiden Oberflächen des Halbleiterwafers reflektierten Lichtwellenlängen aufgefächert und invertiert und mittels einer Fourieranalyse bzw. einer Fouriertransformation über ein FDOCT-Verfahren kontinuierlich ausgewertet. Dabei ist es nicht entscheidend, ob der Messkopf von unten, beispielsweise durch eine zentrale Öffnung, die Waferdicke erfasst oder ob von oberhalb des Halbleiterwafers die Waferdicke überwacht wird.

In einer bevorzugten Ausführungsform , die das 1D-se FDOCT-Verfahren oder das 1D-te FDOCT-Verfahren betrifft, weist das Spektrometer ein optisches Gitter auf, wobei das optische Gitter zum Auffächern der spektralen Verteilung der reflektierten Strahlung ausgebildet ist.

Der Messkopf wird in einer weiteren Ausführungsform der Erfindung durch eine optisch transparente, insbesondere infrarottransparente, Schutzscheibe, die bevorzugt Saphir aufweist, vor den Ätzlösungen geschützt. Saphir ist ein monokristallines Aluminiumoxid, das von einer Siliziumätzlösung nicht angegriffen werden kann. Bei Einsatz des Messkopfes für andere Ätzlösungen von anderen Halbleitermaterialien sind entsprechend angepasste Schutzscheiben oder Schutzfolien vorgesehen.

In einer weiteren Ausführungsform ist die Auswerteeinheit zusätzlich zum Ermitteln einer Dicke d_{f}(t) und Gleichmäßigkeit eines Ätzfilms aus Ätzflüssigkeit ausgebildet.

In einer weiteren Ausgestaltung ist der Strahlteiler ein optischer Koppler. Ferner kann die Überwachungsvorrichtung zumindest einen ersten Lichtwellenleiter, der den Messkopf mit dem optischen Koppler verbindet, zumindest einen zweiten Lichtwellenleiter, der den optischen Koppler mit der Lichtquelle verbindet und zumindest einen dritten Lichtwellenleiter, der den optischen Koppler mit dem Spektrometer verbindet, aufweisen.

Die Erfindung betrifft eine Dünnungsvorrichtung mit einer Nassätzeinrichtung und einer Überwachungsvorrichtung nach einer der vorhergehenden Ausführungsformen.

Die Dünnungsvorrichtung weist die bereits im Zusammenhang mit der Überwachungsvorrichtung genannten Vorteile auf, welche an dieser Stelle zur Vermeidung von Wiederholungen nicht nochmals aufgeführt werden.

Die Nassätzeinrichtung weist bevorzugt mindestens eine drehbare Haltevorrichtung für den zu dünnenden Halbleiterwafer auf. Die Haltevorrichtung kann dabei ein von einem drehzahlgesteuerten Motor angetriebener Drehtisch sein.

Die Dünnungsvorrichtung weist einen Spender für eine Ätzflüssigkeit zum Dünnen des Halbleiterwafers auf. Der Spender kann unter- schiedliche Düsen aufweisen wie eine Tropfdüse oder eine Sprühdüse, wobei die Tropfdüse Flüssigkeitstropfen generiert, während die Sprühdüse einen Nebel aus Flüssigkeit bildet. In einer Ausführungsform der Erfindung ist diese Düse des Spenders mittig über dem rotierenden und zu dünnenden Halbleiterwafer feststehend vorgesehen. Da das Zentrum des Halbleiterwafers gegenüber den Randbereichen weniger bewegt wird und damit eine geringere Zentrifugalkraft für den Ätzfilm entwickelt, ist der Abtrag bzw. die Abnahme der Dicke im Zentrum geringer als zum Rand des Halbleiterwafers hin, wenn die Ätzvorrichtung lediglich für einen Halbleiterwafer ausgestattet ist. Andererseits kann die Düse auch schwenkbar sein, um den Dünnungsvorgang zu vergleichmäßigen.

Die Dünnungsvorrichtung weist eine Kopplungseinheit und eine Steuer- bzw. Regeleinheit der Nassätzeinrichtung auf, wobei die Kopplungseinheit mit der Auswerteeinheit und der Steuereinheit verbunden ist und wobei die Kopplungseinheit zum Stoppen des Ätzvorgangs bei Erreichen einer vorgegebenen Enddicke dz des gedünnten Halbleiterwafers ausgebildet ist. Die Kopplungseinheit ist bevorzugt über Signalleitungen mit der Auswerteeinheit und der Steuereinheit verbunden und kann in der Überwachungsvorrichtung oder in der Steuereinheit integriert sein. Vorzugsweise ist die Kopplungseinheit mehrere Meter zum Messkopf versetzt und abgesetzt von der Nassätzeinrichtung zum Dünnen des Halbleiterwafers angeordnet und weist einen Monitor mit entsprechender Anzeige und Bedierioberfläche auf. Dazu kann der Monitor einen Touchscreen besitzen.

Die letztgenannten Ausführungsformen haben den Vorteil, dass eine Verfahrenssteuerung des Dünnens von Halbleiterwafern unter Vermeidung einer Überätzung verbessert ist. Die Spezifikation der Dickentaleranzen kann auf wenige 10 Nanometer beim Dünnen von Halbleiterwafern begrenzt werden. Selbst wenn die Ätzwirkung der Ätzlösung von Alterungserscheinungen abhängig ist, kann die vorgesehene Enddicke der Halbleiter eines gesamten Loses mit einer Vielzahl von Halbleiterwafem unabhängig von derartigen Alterungserscheinungen einer Ätzflüssigkeit erreicht werden. Die Dosierung der Ätzzusammensetzung und der Menge der zuzuführenden Ätzlösung kann mit Hilfe dieser Dünnungsvorrichtung gesteuert bzw. geregelt werden. Schließlich kann eine geringere Enddicke für Halbleiterwafer beim Dünnen erreicht werden. Darüber hinaus ist ein Vorteil dieser Dünnungsvorrichtung, dass ein vorbereitender Prozess mit so genannten 'Dummy Wafern' eingespart werden kann. Auch die Anzahl der sonst üblichen Verfahrensschritte beim chemisch-mechanischen Dünnungsprozess von Halbleiterwafern kann reduziert werden, zumal Zwischenschritte zum Überprüfen des Ergebnisses völlig entfallen können.

Die Anzahl der Messpunkte pro Umdrehung des Halbleiterwafers kann in Abhängigkeit von der Rechenkapazität und der Rechengeschwindigkeit der Auswerteeinheit gegenüber dem bekannten Abtastverfahren mit Hilfe einer Galvanometerreferenz um mehrere Größenordnungen erhöht werden, so dass die Genauigkeit der einstellbaren Enddicke auf± 70 Nanometer pro Wafer voreingestellt werden kann. Mit Hilfe der neuen Dünnungsvorrichtung wird eine von dem Zustand der Ätzlösung unabhängig hohe Reproduzierbarkeit der voreinstellbaren Enddicke des gedünnten. Halbleiterwafers erreicht, so dass bei einem Los von tausend Wafern eine, Streuung der Waferdicke unterhalb von beispielsweise ± 0,5 [!m erreichbar ist.

Die Steuereinheit weist einen Regler auf, der zum Regeln einer Menge der von dem Spender abzugebenden Ätzflüssigkeit in Abhängigkeit von der Dicke df(t) des aufgebrachten Ätzfilms aus Ätzflüssigkeit und/ oder in Abhängigkeit von der Dickenabnahme d(t) des Halbleiterwafers ausgebildet ist.

In einer weiteren Ausführungsförm der Dünnungsvorrichtung ist diese zum Dünnen von Siliziumwafern ausgelegt. Das bedeutet, dass die Dünnungsvorrichtung und dabei bevorzugt die Nassätzeinrichtung eine Ätzlösung aus Flusssäure und einem Oxidationsmittel wie Salpetersäure, gelöstes Peroxidsulfat oder gelöste Ce(IV)-Salze dem Spender zuführt, der über eine schwenkbare oder eine feststehende Düse für den rotierenden Siliziumhalbleiterwafer einen Ätzfilm erzeugt. Dieser Ätzfilm wird durch die Rotation der drehbaren Haltevorrichtung vergleichmäßigt und in seiner Ätzwirkung durch eine Pufferlösung, die Schwefelsäure und/oder Phosphorsäure aufweisen kann, gesteuert. Außerdem soll die mit dem Ätzfilm zu versehende Oberfläche des Siliziumwafers möglichst gleichmäßig von dem Ätzfilm benetzt werden, wozu der Ätzlösung ein flüssiges oder verflüssigtes Benetzungsmittel beigemischt sein kann.

Das bedeutet, dass der Spender in dieser Ausführungsform mit mindestens vier Säurebehältern zusammenwirkt, die an die Steuereinheit angeschlossen sind, mit der die Zusammensetzung und die Menge der Ätzlösung, der Pufferlösung und des Benetzungsmittels gesteuert wird. Dabei kann das Mischungsverhältnis der Säuren an eine durch die Messeinrichtung erfasste Dickenabnahme d(t) während des Dünnens des Halbleiterwafers anpassbar werden. Außerdem ist an dem Spender eine Spülmittelversorgung angeschlossen, mit welcher der Ätzvorgang bei Erreichen der vorgesehenen Enddicke des zu dünnenden Siliziumwafers durch die Steuereinheit gestoppt wird.

Neben der Versorgung des Spenders mit entsprechenden Ätz- und Spülmitteln ist von der Art des Halbleiterwafers, beispielsweise einem zu dünnenden Siliziumwafer, auch der Wellenlängenbereich der Lichtquelle abhängig. Für sichtbares Licht ist ein Siliziumwafer nicht transparent, so dass ein weißes, sichtbares Licht als Lichtquelle ungeeignet ist. Die für die Dickenmessung von Siliziumwafern vorgesehene Lichtquelle weist ein Lichtwellenband auf, das zumindest teilweise oberhalb der Absorptionskante liegt. In einem bevorzugten Ausführungsbeispiel weist die Lichtquelle ein Lichtwellenband von etwa 100 Nanometer im nahen Infrarotbereich zwischen 1,25 µm bis 1,35 µm oder zwischen 1,5 µm bis 1,6 µm auf. Es können jedoch auch Halbleiterwafer, die bei sichtbarem Licht bereits transparent sind, wie GaAs und InP, mit Hilfe der Überwachungsvorrichtung beim Dünnen des Halbleiterwafers gemessen werden, jedoch sind dazu andere Ätzlösungen, Pufferlösungen und Benetzungsmittel erforderlich.

Die für sichtbares Licht nicht transparenten Halbleiterwafer aus GaInAs oder InAs können mit entsprechend angepassten Infrarotlichtwellenbändern mit der erfindungsgemäßen Überwachungsvorrichtung beim Dünnen der Halbleiterwafer gemessen werden. Im Allgemeinen kann jedes Halbleitermaterial, insbesondere Halbleitermaterialien der III-V-Verbindungen oder II-VI-Verbindungen, mit der erfindungsgemäßen Überwachungsvorrichtung beim Dünnen mehrerer Halbleiterwafer kontinuierlich überwacht und gemessen werden.

Die Dicke und Gleichmäßigkeit des Ätzfilms kann durch Steuerung der Drehzahl des Antriebsmotors der drehbaren Haltevorrichtung mit Hilfe der Steuereinheit gesteuert bzw. geregelt werden und durch Messen über die Überwachungsvorrichtung kann auch eine Ätzfilmdicke regelbar eingestellt werden. Dazu verfügt die Steuereinheit der Nassätzeinrichtung zusätzlich über eine Regeleinheit.

In einem anderen Aufbau der Dünnungsvorrichtung ist es auch vorgesehen, mehrere Halbleiterwafer im Randbereich eines Rotationstisches anzuordnen, um die Ätzwirkung zu vergleichmäßigen. Auch in diesem Fall kann das Dünnen mehrerer Halbleiterwafer einer einzelnen rotierenden Haltevorrichtung mit der Überwachungsvorrichtung kontinuierlich erfasst werden. Bei einer derartigen Dünnungsvorrichtung mit einer Nassätzeinrichtung zum Dünnen eines oder mehrerer Halbleiterwafer sind die Oberflächen mit eingebrachten Halbleiterstrukturen auf einer der zu ätzenden Oberfläche gegenüberliegenden Seite des Halbleiters angeordnet, die nicht den Ätzflüssigkeiten bzw. den Spülflüssigkeiten ausgesetzt ist.

Eine weitere Möglichkeit, den Ätzfilm zu vergleichmäßigen besteht darin, den Ätzfilm auf dem Drehtisch zu erzeugen und die zu ätzende Oberfläche des Halbleiterwafers auf diesen Ätzfilms aufzudrücken. Dabei kann der Messkopf zur Erfassung der Waferdicke beim Dünnen des Halbleiterwafern in einer derartigen Ätzvorrichtung von unten auf die zu ätzende Oberfläche des Halbleiterwafers, beispielsweise durch eine zentrale Öffnung in dem Drehtisch, gerichtet werden.

Der Messkopf selber ist in einer Ausführungsform über einen Multimode-Lichtwellenleiter mit der Auswerteeinheit verbunden. Dazu weist die Überwachungsvorrichtung den optischen Koppler auf, der einerseits das Licht der Lichtquelle zu dem Messkopf leitet, andererseits die vom Messobjekt, wie einem Halbleiterwafer, reflektierte Strahlung dem Spektrometer zuführt. Dort wird das Spektrum des reflektierten Lichtes auf einer Detektorzeile abgebildet. Das ausgelesene Spektrum wird auf die Wellenzahl umskaliert und fouriertransformiert. Aus den Positionen der in der Fouriertransformation im FDOCT-Verfahren auftretenden Peaks werden die optischen Weglängen der zugehörigen Schichten aus dem reflektierten Spektrum bestimmt.

Die ermittelten Messwerte können an der Kopplungseinheit direkt abgelesen werden, an der bevorzugt ein zweizeiliges LC-Display zur Verfügung steht, oder sie können an einem Monitor eines Zentralrechners angezeigt werden, der über einen Touchscreen verfügt, mit dem die einzelnen Anfangs- und Randbedingungen wie Brechungsindices des zu untersuchenden Materials, Anzahl der unterschiedlichen Schichten, Schwellwerte für die Reflexionsintensitäten usw. eingegeben werden können.

Während die Überwachungsvorrichtung die optischen Längen von Einzelschichten ermittelt, kann ein Messprogramm mit einem angeschlossenen PC daraus die Schichtdickenbestimmung der für die Dickenmessung eingesetzten Materialien ermitteln und am Monitor darstellen. Anstelle eines Touchscreens können auch Funktionstasten des PC eingesetzt werden. Die hohe Messrate von bis zu 4000 Messungen pro Sekunde sowie der relativ kleine Messfleck in einer flächigen Erstreckung von wenigen µm² (Quadratmikrometern) ermöglichen auch eine ortsaufgelöste Schichtdickenmessung. Die Überwachungsvorrichtung kann auch mit einem Mehrachsen-Positioniersystem ausgestattet sein, um die flächige Verteilung der Enddicke nach Beendigung des Ätzvorgangs aufzuzeigen.

Da der Messkopf ohne bewegliche und ohne elektronische Komponenten arbeitet, ist er robust und kann über mehrere Meter durch die Lichtwellenleiter mit einer räumlich entfernt angeordneten Messeinrichtung und der in der Messeinrichtung zur Verfügung stehenden Elektronik verbunden sein, so dass die Messeinrichtung abgesetzt vom Messkopf betrieben werden kann.

Für unterschiedliche Anforderungen stehen verschiedene Messköpfe zur Verfügung, wobei ein bevorzugter Messkopf einen Messbereich für das Dünnen von Halbleiterwafern von 2 bis 250 µm mit einer Auflösung von 10 nm und einer Reproduzierbarkeit von 20 nm bei einem Brechungsindex von n=1 abdeckt. Der Arbeitsabstand des Messkopfes von dem zu dünnenden Objekt kann ohne negativen Einfluss auf das Messergebnis um mehrere Millimeter variieren, da kontinuierlich eine Halbleiterwaferdicke oder eine Dicke eines Ätzfilms gemessen werden und nicht die Zunahme des Abstandes zwischen Messkopf und zu dünnendem Objekt erfasst wird. Bei dem oben angegebenen Messkopf wird neben der Auflösung von 10 nm eine Absolutgenauigkeit von 70 nm erreicht.

Die sonst üblichen Probleme, z.B. durch Abschattungseffekte bei einer Triangulation und die Probleme von hohen Anforderungen an die Qualität der Oberfläche bei monochromatischen und interferometrischen Messungen, werden mit der erfindungsgemäßen Vorrichtung überwunden. Es können sowohl glatte als auch raue, hoch reflektierende und durchlässige Oberflächen mit Hilfe der Vorrichtung vermessen werden.

Ein Verfahren zum Überwachen eines Dünnens mindestens eines optisch transparenten Halbleiterwafers in einer Nassätzeinrichtung, wobei die Nassätzeinrichtung mindestens eine drehbare Haltevorrichtung aufweist, weist die nachfolgenden Verfahrensschritte auf. In der Nassätzeinrichtung wird mindestens ein Halbleiterwafer auf der drehbaren Haltevorrichtung fixiert. Danach kann der Start eines kontinuierlichen Messvorgangs unter Aktivieren einer Lichtquelle und Emittieren kohärenten Lichts der Lichtquelle im nahen Infrarotbereich in einem bevorzugt mehrere 10 Nanometer breiten Lichtwellenband, mit dem ein Messkopf den rotierenden Halbleiterwafer bestrahlt, wobei reflektierte Strahlung vom Messkopf empfangen wird, und unter Aktivieren eines Spektrometers, das die reflektierte Strahlung empfängt, erfolgen. Gleichzeitig oder nachfolgend kann der Start eines Ätzvorgangs zur Dünnung des rotierenden Halbleiterwafers unter Aufbringen einer Ätzlösung mittels eines Spenders, bevorzugt unter Regelung der Menge der Ätzlösung und der Drehzahl des Halbleiterwafers mittels einer Steuereinheit, erfolgen. Zudem erfolgt ein kontinuierliches Auswerten der spektrometrisch aufgefächerten reflektierten Strahlung zum Ermitteln einer erreichten Dicke d(t) des Halbleiterwafers während des Dünnens des Halbleiterwafers mittels eines Verfahrens, ausgewählt aus der Gruppe, bestehend aus einem 1D-se FDOCT-Verfahren (eindimensionales räumlich kodiertes Fourier Domain Optical Coherence Tomography-Verfahren), einem 1D-te FDOCT-Verfahren (eindimensionales zeitlich kodiertes Fourier Domain Optical Coherence Tomography-Verfahren) und einem 1D-se TDOCT-Verfahren (eindimensionales räumlich kodiertes Time Domain Optical Coherence Tomography-Verfahren).

Dieses Verfahren hat den Vorteil, dass gegenüber dem aus dem Stand der Technik bekannten Verfahren gemäß US 6,897,964 B2 zum Dünnen von Halbleiterwafern auf eine optische Referenzlichterzeugung bzw. einen optischen Referenzpfad verzichtet werden kann. Die kontinuierliche Erfassung der Waferdicke eines zu dünnenden Halbleiterwafers wird vielmehr durch die Spektralanalyse der reflektierten Strahlung von den beiden Oberflächen des Halbleiterwafers über ein TDOCT-Verfahren oder mittels einer Fouriertransformation über ein FDOCT-Verfahren ermittelt.

Jede Grenzschicht erzeugt ein reflektiertes Spektrum, das durch die Fouriertransformation zu einem eindeutigen Peak führt, mit dem die optischen Längen der Einzelschichten, die beim Dünnen in einem Abstand zu dem Messkopf angeordnet sind, mit einer hohen Abtastrate ermittelt werden können. Wie bereits mehrfach erwähnt, hängt diese Abtastrate lediglich von der Rechengeschwindigkeit und der Rechenkapazität der Auswerteeinheit ab, so dass bis zu 4000 Dickenmessungen pro Sekunde erfolgen können, womit gleichzeitig eine hohe Reproduzierbarkeit der ermittelten Werte verbunden ist. Dabei wird das Ergebnis nicht durch rotationsbedingte Schwankungen des Abstandes zwischen rotierender Haltevorrichtung und Messkopf beeinträchtigt, da bei diesem Verfahren die Schichtdicken erfasst werden und nicht die Abstände zwischen Messkopf und Oberflächen der zu messenden Schichten.

In einer bevorzugten Ausführungsform wird weiterhin eine Enddicke des zu dünnenden Halbleiterwafers in eine Kopplungseinheit oder Kontrolleinheit eingegeben, die mit der Auswerteeinheit der Überwachungsvorrichtung und einer Steuereinheit der Nassätzeinrichtung verbunden ist. Abschließend erfolgt in dieser Ausführungsform ein Stoppen des Ätzvorgangs beim Erreichen der vorgegebenen Enddicke für den gedünnten Halbleiterwafer.

Vorzugsweise wird bei diesem Verfahren die Eingabe der Enddicke, insbesondere auf wenige 100 Nanometer in Stufen von 10 Nanometer, an der Kopplungseinheit oder über einen Monitor mit Touchscreen eingestellt. Anstelle des Touchscreen können auch Funktionstasten eines PC entsprechend belegt werden.

Das Fixieren des Halbleiterwafers auf der drehbaren Haltevorrichtung kann, vorzugsweise bei Halbleiterwafern für Enddicken unter 150 Mikrometern, mittels eines Substrats, auf das der zu dünnende Halbleiterwafer mit einer Klebstoffschicht fixiert ist, erfolgen. Soweit diese Klebstoffschicht für das Lichtwellenband der Lichtquelle transparent ist, kann auch die Dicke der Klebstoffschicht beim Dünnen des Halbleiterwafers überprüft werden.

Dazu wird der zu dünnende Halbleiterwafer zunächst auf ein Substrat aufgeklebt und das Substrat dann mittels Vakuum oder mittels eines Permanentmagneten auf der drehbaren Halbleitervorrichtung fixiert. Für eine permanentmagnetische Fixierung des Substrats auf der Haltevorrichtung weist dieses Substrat ein ferromagnetisches Material wie Kobalt, Nickel, Eisen oder Legierungen derselben auf.

Insbesondere bei größeren Enddicken kann der Halbleiterwafer mittels Vakuum auf dem Drehtisch ohne Substrat fixiert werden.

Zusätzlich kann zu der kontinuierlichen Erfassung der Dicke des zu dünnenden Halbleiterwafers die Dicke und Gleichmäßigkeit eines Ätzfilms aus aufgebrachter Ätzflüssigkeit erfasst werden und die Menge der von einem Spender aufzubringenden Ätzflüssigkeit und/oder die Drehzahl der Haltervorrichtung in Abhängigkeit der Dickenmessung des Ätzfilms geregelt werden. Für ein relativ gleichmäßiges Dünnen des Halbleiterwafers ist ein gleichmäßiges Abfließen und ein gleichmäßiges Zufließen der Ätzlösung, der Pufferlösung und/oder des Benetzungsmittels erforderlich, was ebenfalls mit Hilfe der Auswerteeinheit ständig überprüft und über die Kopplungseinheit einem Regler für die Zusammensetzung der Ätzflüssigkeit und der Drehzahl des Motors der rotierenden Haltevorrichtung über entsprechende Signalleitungen zugeführt werden kann. Dabei kann die Menge und/oder die Zusammensetzung der aufzubringenden Ätzflüssigkeit in Abhängigkeit der Dickenabnahme des Halbleiterwafers kontinuierlich während des Ätzens geregelt werden.

In einer Ausführungsform, die das 1D-se FDOCT-Verfahren oder das 1D-te FDOCT-Verfahren betrifft, fächert das Spektrometer die reflektierte Strahlung spektral auf. Das Auffächern der spektralen Verteilung der reflektierten Strahlung kann mittels eines optischen Gitters und einer nachgeordneten Diodenzeile erfolgen. Die ermittelten Wellenlängen der reflektierten Strahlung werden für die genannten FDOCT-Verfahren in einer weiteren Ausführungsform invertiert und dem Spektrometer zugeführt.

Als Ätzflüssigkeit für einen Siliziumwafer wird eine Ätzlösung aus Flusssäure und einem Oxidationsmittel wie Salpetersäure, gelöstes Peroxidsulfat oder gelöste Ce(IV)-Salze über den Spender auf die zu dünnende Oberfläche des Halbleiterwafers aufgebracht, und zur Pufferung der Ätzrate können Schwefelsäure und/oder Phosphorsäure zugegeben werden, und zur Verbesserung der Benetzung flüssige Benetzungsmittel zugemischt sein.

Der Start des Messvorgangs kann auch nach dem Start des Ätzvorgangs erfolgen, da die Dickenmessung eine Absolutmessung ist und somit der Start des Messvorgangs auch kurz vor Erreichen der Enddicke noch einsetzen kann und den Zeitpunkt des Stoppens und damit des Ersetzens der Ätzlösung durch eine Spülmittellösung noch rechtzeitig einsetzen kann. Der Spülvorgang wird gestartet, sobald das Erreichen der Enddicke durch die Auswerteeinheit signalisiert wird. An den Spülvorgang kann sich ein Trockenschleudern anschließen. Schließlich ist es möglich, wie oben bereits erwähnt, durch entsprechende Mehrachsen-Positioniersysteme die Verteilung der Enddicke oder die Einhaltung bzw. Überschreitung der Enddicke in Bezug auf die gesamte geätzte Oberfläche genau nachzumessen.

Der mindestens eine Halbleiterwafer kann ein zu dünnender Siliziumwafer sein. Weiterhin kann der mindestens eine Halbleiterwafer ein zu dünnender Wafer aus einem III-V oder II-VI-Halbleitermaterial sein. Der mindestens eine Halbleiterwafer kann insbesondere ein zu dünnender Wafer aus einem der Halbleitersubstanzen GaAs, InP, GalnAs oder InAs sein.

Die Erfindung wird nun anhand der beigefügten Figuren näher erläutert.

Figur 1 zeigt eine schematische Struktur einer Dünnungsvorrichtung mit einer Überwachungsvorrichtung für ein in-situ Messen von Waferdicken beim Dünnen von Halbleiterwafern zum Überwachen des Dünnens des Halbleiterwafers gemäß einer Ausführungsform der Erfindung;

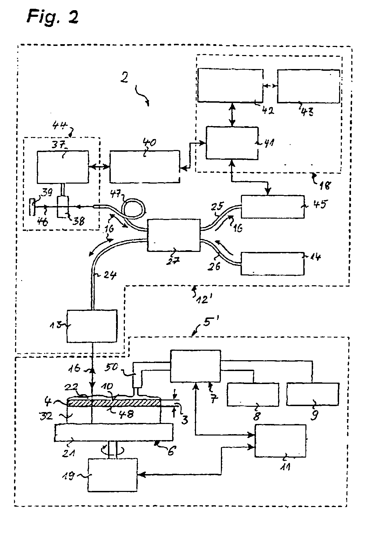

Figur 2 zeigt eine schematische Struktur einer Vorrichtung für ein Messen von Waferdicken beim Dünnen von Halbleiterwafern gemäß dem Stand der Technik.

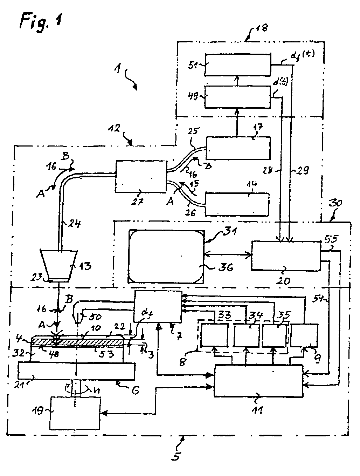

Figur 1 zeigt eine schematische Struktur einer Dünnungsvorrichtung 1 mit einer Überwachungsvorrichtung 12 für ein in-situ Messen von Waferdicken 3 beim Dünnen von Halbleiterwafern 4 zum Überwachen des Dünnens des Halbleiterwafers 4 gemäß einer Ausführungsform der Erfindung. Dazu besteht die Dünnungsvorrichtung 1 im Wesentlichen aus zwei Einrichtungen, nämlich einer Nassätzeinrichtung 5 zum Dünnen mindestens eines Halbleiterwafers 4 und der Überwachungsvorrichtung 12 zum Überwachen des Dünnens des Halbleiterwafers 4 und zum Messen der Dicke 3 des sich drehenden Halbleiterwafers 4 beim Dünnen desselben. Zwischen der Nassätzeinrichtung 5 und der Überwachungsvorrichtung 12 ist eine Kopplungseinheit 20 bzw. eine Eingabe- und Kopplungseinheit 30 angeordnet, über die Rand- und Anfangsparameter, Schwellwerte für Lichtintensitäten und andere Parameter eingegeben und Messergebnisse dargestellt werden können.

Die Nassätzeinrichtung 5 zum Dünnen mindestens eines Halbleiterwafers weist eine drehbare Haltevorrichtung 6 für einen zu dünnenden Halbleiterwafer 4 auf. Ferner hat die Nassätzeinrichtung 5 einen Spender 7 für Ätzflüssigkeiten 8 und Spülflüssigkeiten 9 zum Aufbringen auf eine Oberfläche 10 des rotierenden und zu dünnenden Halbleiterwafers 4. Schließlich besitzt die Nassätzeinrichtung 5 eine Steuereinheit 11 für ein Steuern der aufzubringenden Menge der Ätzflüssigkeit 8 oder Spülflüssigkeit 9 und für ein Steuern der Drehzahl n der Haltevorrichtung 6.

Die zweite Einrichtung, nämlich die Überwachungsvorrichtung 12 zum Überwachen des Dünnens des Halbleiterwafers 4 und zum Messen der Waferdicke 3 des sich drehenden Halbleiterwafers 4 weist einen Messkopf 13 auf, der kontaktfrei in einem Abstand zu der zu ätzenden Oberfläche 10 des Halbleiterwafers 4 angeordnet ist. Dabei wird die Genauigkeit der Messung der Waferdicke 3 des Halbleiterwafers 4 nicht durch den Abstand des Messkopfes 13 von der Oberfläche 10 des rotierenden Halbleiterwafers 4 beeinträchtig. Die Überwachungsvorrichtung 12 weist darüber hinaus eine Lichtquelle 14 mit kohärenter Lichtemission 15 im nahen Infrarotbereich in einem mehrere 10 Nanometer breiten Lichtwellenband, mit dem der Messkopf 13 den Halbleiterwafer 4 bestrahlt und die reflektierte Strahlung 16 empfängt, auf. In der gezeigten Ausführungsform der Erfindung liegt der Infrarotbereich des Lichtwellenbandes zwischen 1,25 und 1,35 µm, so dass ein 100 nm breites Lichtwellenband über den Messkopf 13 in Pfeilrichtung A den Halbleiterwafer 4 auf der rotierenden Haltevorrichtung 6 kontaktfrei bestrahlt, und in Pfeilrichtung B wird die reflektierte Strahlung 16 einem Spektrometer 17 zugeführt.

Der Messkopf 13 wird vor den Ätzflüssigkeiten 8, die mittels einer Düse 50 von dem Spender 7 auf die Oberfläche 10 des Halbleiterwafers 4 aufgebracht werden, durch eine infrarottransparente Schutzscheibe 23 aus Saphir geschützt. Das Material der Schutzscheibe 23 ist kristallines optisch transparentes Al₂O₃ und damit gegenüber den Ätzlösungen für einen Siliziumhalbleiterwafer unempfindlich. Der Messkopf 13 ist über einen ersten optischen Lichtwellenleiter 24 mit einem Strahlteiler, der in der gezeigten Ausführungsform ein optischen Koppler 27 ist, verbunden, der eine Komponente der Überwachungsvorrichtung 12 darstellt, wobei dieser optische Lichtwellenleiter 24 mehrere Meter lang sein kann, damit die Elektronik der Messeinrichtung von dem robusten Messkopf und der aggressiven Nassätzeinrichtung 5 zum Dünnen des Halbleiterwafers entfernt angeordnet werden kann. Diese Elektronik kann auch in einem separaten Messraum vorgesehen werden.

Der optische Koppler 27 verbindet über den ersten optischen Lichtwellenleiter 24 und einen zweiten Lichtwellenleiter 26 die Infrarotlichtquelle 14 des nahen Infrarots mit dem Messkopf 13, wobei eine kohärente Lichtemission 15 über den zweiten Lichtwellenleiter 26, den optischen Koppler 27 und den ersten Lichtwellenleiter 24 dem Messkopf 13 zugeführt wird. Die reflektierte Strahlung 16 wird in Pfeilrichtung B einem Spektrometer 17 über den optischen Koppler 27 und einen dritten Lichtwellenleiter 25 dem Spektrometer 17 zugeführt.

Das Spektrometer 17 fächert die reflektierte Strahlung 16 nach Invertierung der reflektierten Lichtwellenlängen spektral auf und leitet das gemessene Spektrum zur Waferdickenermittlung der Auswerteeinheit 18 zu. Die Auswerteeinheit 18 weist zwei Messblöcke auf. Ein erster Messblock 49 ermittelt in der gezeigten Ausführungsform mittels eines FDOCT-Verfahrens die Waferdicke d(t) und liefert den ermittelten Wert über eine Signalleitung 28 an die Kopplungseinheit 20. Ein zweiter Messblock 51 ermittelt in der gezeigten Ausführungsform mittels eines FDOCT-Verfahrens die augenblickliche Dicke d_{f}(t) des Ätzfilms und liefert das ermittelte Ergebnis kontinuierlich über die Signalleitung 29 an die Kopplungseinheit 20. Anstelle mehrerer Signalleitungen kann auch eine Multiplexleitung vorgesehen werden.

Die Kopplungseinheit 20 gehört zu einer Eingabe- und Kopplungseinheit 30, die auch als Kontrolleinheit arbeitet und die ein zweidimensionales LC-Display aufweisen kann, wie beispielsweise einen Monitor 31, der in dieser Ausführungsform der Erfindung mit einem Touchscreen 36 ausgestattet ist, so dass nicht nur Messergebnisse angezeigt werden können, sondern auch Rand- und Anfangsparameter über den Touchscreen 36 und entsprechende Eingabemasken eingegeben werden können. Die Kopplungseinheit 20 verbindet die Auswerteeinheit 18 mit der Steuereinheit 11 der Nassätzeinrichtung 5 zum Dünnen des Halbleiterwafers 4. Außerdem steht die Steuereinheit 11 mit einem Spender 7 über mehrere Blöcke 33 bis 35 zur Bildung einer Ätzflüssigkeit 8 und mit einem Block für die Spülflüssigkeit 9 in Verbindung.

Dabei wird eine Ätzlösung in dem Block 33 aus zwei Lösungskomponenten für beispielsweise einen Siliziumwafer zusammengestellt, die aus Flusssäure und einem Oxidationsmittel wie Salpetersäure, gelöstes Peroxidsulfat oder gelöste Ce(IV)-Salze besteht. In dem Block 34 wird ein Benetzungsmittel eventuell zugesetzt und im Block 35 wird eine Pufferlösung, die aus Schwefelsäure und/oder Phosphorsäure besteht, bereitgestellt und dem Spender 7 zugeführt. Dabei können die Zusammensetzungen und Mischungsverhältnisse dem Halbleitersubstratmaterial angepasst sein, wobei die oben genannten Beispiele der Lösungen für das Dünnen eines Siliziumwafers gelten.

Da diese Lösungsmittel hochtransparent sind, jedoch sich in ihrem Brechungsindex von dem Brechungsindex des Halbleiterwafers und dem Brechungsindex der umgebenden Luft unterscheiden, kann auch die Dicke dₜ(t) eines Ätzfilms 22, der sich auf dem rotierenden Halbleiterwafer 4 ausbildet, erfasst und in der Auswerteeinheit 18 bestimmt werden, so dass die Steuereinheit 11 nicht nur die Drehzahl n eines Motors 19 der drehbaren Haltevorrichtung 6 steuert, sondern auch die Zusammensetzung und die Einzelmengen der im Spender 7 zu mischenden und über die Düse 50 auszubringenden Ätzflüssigkeit 8 definieren kann. Die Spülflüssigkeit 9 kommt erst zum Einsatz, wenn die vorgegebene Enddicke d_{z} des zu dünnenden Halbleiterwafers 4 erreicht ist und der Ätzvorgang zu stoppen ist.

Die Fixierung des Halbleiterwafers 4 auf dem Drehtisch 21 der rotierenden drehbaren Haltevorrichtung 6 kann unterschiedlich ausgeführt sein. In dieser Ausführungsform der Erfindung ist der Halbleiterwafer 4 mit Hilfe einer Klebstoffschicht 53 auf einem ferromagnetischen Substrat 32 fixiert, wobei der Drehtisch 21 einen Permanentmagneten aufweist, welcher das ferromagnetische Substrat 32 auf dem Drehtisch 21 fixiert. In einer anderen Ausführungsform der Erfindung kann die drehbare Vorrichtung 6 auch einen Vakuumdrehtisch 21 aufweisen, der mittels Vakuum ein entsprechendes Substrat 32 auf dem Drehtisch fixiert. Ein derartiges Substrat wird dann eingesetzt, wenn Enddicken unter 150 Mikrometern erreicht werden sollen. Für größere Enddicken kann der Halbleiterwafer 4 mittels Vakuum auf dem Drehtisch 21 fixiert werden.

Die Klebstoffschicht 53 weist vorzugsweise einen Thermoplast auf, so dass bei geringer Erwärmung des Substrats 32 der Halbleiterwafer 4 von dem Substrat 32 nach seinem Dünnen herunter geschoben werden kann, wobei vielfach der Halbleiterwafer 4 mit dem Substrat 32 in eine Trenneinrichtung eingegeben wird, um zunächst den gedünnten Halbleiterwafer 4 in einzelne gedünnte Chips zu trennen und dann die einzelnen Chips von dem Substrat 32 zu lösen. Da derartige Klebstoffschichten 53 ebenfalls transparent sind, kann mit Hilfe der Messeinrichtung 12 auch die Dicke der Klebstoffschicht 53 vor, nach oder während des Dünnätzens erfasst und überprüft werden.

Da sowohl die Grenzschicht zwischen Ätzfilm 22 und Oberfläche 10 des Halbleiterwafers 4 als auch die Grenzschicht zwischen Klebstoffschicht und Oberfläche 48 des Halbleiterwafers 4 mit Hilfe der spektrometrischen Auffächerung des Spektrums der reflektierten Strahlung 16 ermittelt werden kann, wird somit diese Vorrichtung 1 für das Erfassen einer Mehrzahl von Schichten eingesetzt. Von Bedeutung für die Dünnung des Halbleiterwafers 4 ist dabei die ständig abnehmende Waferdicke 3 bzw. das in der Auswerteeinheit 18 ermittelte d(t) sowie die Dicke d_{f} (t) des Ätzfilms 22.

Die Dicke d_{f} (t) des Ätzfilms 22 kann mit Hilfe der Drehzahl n des Antriebsmotors 19 des Drehtisches 21 geändert werden, während die Menge und/oder die Zusammensetzung der Ätzflüssigkeit 8 mit Hilfe der oben genannten drei Blöcke 33 bis 35 und der Steuereinheit 11 einstellbar bzw. regelbar ist. Die Düse 50 ist in dieser Ausführungsform der Erfindung zentral auf die Mitte des Halbleiterwafers 4 ausgerichtet oder kann horizontal über den Halbleiterwafer 4 geschwenkt werden. Diese Dünnungsvorrichtung 1 kann lediglich einen einzelnen Halbleiterwafer dünnen.

Jedoch können auch mehrere Halbleiterwafer 4 auf einem vergrößerten Drehteller 21 in dessen Randbereichen angeordnet werden, während die Düse 50 des Spenders 7 zentral auf die Mitte des Drehtisches 21 gerichtet ist. Dabei ist es von Vorteil, wenn das Substrat 32 die gesamte Oberfläche des Drehtisches 21 bedeckt und die einzelnen zu dünnenden Halbleiterwafer im Randbereich des gemeinsamen Substrats 22 fixiert sind, so dass der Ätzfluss über die Wafer vergleichmäßigt strömt.

Die Eingabe- und Kopplungseinheit 30 kann entweder in die Nassätzeinrichtung 5 zum Dünnen des Halbleiterwafers 4 integriert sein oder zu der Überwachungsvorrichtung 12 gehören. Ferner ist es auch möglich die Eingabe- und Kopplungseinheit 30, die sowohl mit der Auswerteeinheit 18 als auch mit der Steuereinheit 11 lediglich über Signalleitungen 28, 29 sowie 54 und 55 in Verbindung stehen, fern von der Nassätzeinrichtung 5 bzw. der Überwachungsvorrichtung 12 in einem zentralen Überwachungsraum integriert sein. Dieses zeigt, dass die erfindungsgemäße Dünnungsvorrichtung 1 in ihrer Anordnung der einzelnen Komponenten äußerst flexibel ist, wobei lediglich der robuste Messkopf 13 in einem Abstand zu der zu ätzenden Oberfläche 10 des Halbleiterwafers 4 anzuordnen ist.

### Bezugszeichenliste

1 Dünnungsvorrichtung (Ausführungsform der Erfindung)
2 Vorrichtung (Stand der Technik)
3 Waferdicke
4 Halbleiterwafer
5 Nassätzeinrichtung
5' Einrichtung
6 drehbare Haltevorrichtung
7 Spender
8 Ätzflüssigkeit
9 Spülflüssigkeit
10 Oberfläche des rotierenden Halbleiterwafers
11 Steuereinheit
12 Überwachungsvorrichtung
12' Messvorrichtung
13 Messkopf
14 Lichtquelle
15 Lichtemission
16 reflektierte Strahlung
17 Spektrometer
18 Auswerteeinheit
19 Motor
20 Kopplungseinheit
21 Drehtisch
22 Ätzfilm
23 Schutzscheibe des Messkopfes
24 Lichtwellenleiter (von und zum Messkopf)
25 Lichtwellenleiter
26 Lichtwellenleiter
27 optischer Koppler
28 Signalleitung
29 Signalleitung
30 Eingabe- und Kopplungseinheit
31 Monitor
32 Substrat
33 Block für die Ätzlösung
34 Benetzungsmittel
35 Pufferlösung
36 Touchscreen
37 Galvanometer (Spiegelgalvanometer)
38 schwenkendes Glassubstrat
39 Reflektorspiegel
40 optische Bildlängen-Erfassung
41 Signalverarbeitungsschaltung
42 Rohdickenberechnung
43 statistische Dickenberechnung
44 Referenzlichterzeugung
45 Photodetektor
46 optischer Referenzpfad
47 optischer Referenzlichtwellenleiter
48 auf der Haltevorrichtung aufliegende Oberfläche des Halbleiterwafers
49 erster Messblock
50 Düse des Spenders
51 zweiter Messblock
53 Klebstoffschicht
54 Signalleitung
55 Signalleitung
d(t) augenblickliche Waferdicke
Δd(t) Dickenabnahme des Halbleiterwafers
d_{f}(t) augenblickliche Dicke des Ätzfilms
d_{z} Enddicke des Halbleiterwafers
λ Wellenlänge der Lichtstrahlen
n Drehzahl

## Patentansprüche

1. Dünnungsvorrichtung mit einer Nassätzeinrichtung (5) und einer Überwachungsvorrichtung (12) zum Überwachen eines Dünnens mindestens eines Halbleiterwafers (4) in der Nassätzeinrichtung (5), wobei die Überwachungsvorrichtung (12) folgendes aufweist:
- eine Lichtquelle (14) ausgebildet zum Emittieren kohärenten Lichts eines Lichtwellenbandes, für das der Halbleiterwafer (4) optisch transparent ist,
- einen kontaktfrei zu einer zu ätzenden Oberfläche des Halbleiterwafers (4) angeordneten Messkopf (13), wobei der Messkopf (13) zum Bestrahlen des Halbleiterwafers (4) mit dem kohärenten Licht des Lichtwellenbandes und zum Empfangen einer von dem Halbleiterwafer (4) reflektierten Strahlung (16) ausgebildet ist,
- ein Spektrometer (17),
- einen Strahlteiler, über den das kohärente Licht des Lichtwellenbandes auf den Messkopf (13) und die reflektierte Strahlung auf das Spektrometer (17) gelenkt wird, und
eine Auswerteeinheit (18), wobei die Dünnungsvorrichtung eine Kopplungseinheit (20), eine Steuereinheit (11) der Nassätzeinrichtung (5), und einen Spender (7) für eine Ätzflüssigkeit zum Dünnen des Halbleiterwafers (4) aufweist, wobei die Kopplungseinheit (20) mit der Auswerteeinheit (18) und der Steuereinheit (11) verbunden ist und zum Stoppen des Ätzvorgangs bei Erreichen einer vorgegebenen Enddicke (d_{z}) des gedünnten Halbleiterwafers (4) ausgebildet ist,
**dadurch gekennzeichnet,**
- **dass** die Auswerteeinheit (18) zum Ermitteln einer Dicke d(t) des Halbleiterwafers (4) und der Dicke (d_{f}(t)) eines aufgebrachten Ätzfilms (22) aus Ätzflüssigkeit (8) aus der von dem Halbleiterwafer (4) reflektierten Strahlung (16) während des Dünnens des Halbleiterwafers (4) mittels eines Verfahrens, ausgewählt aus der Gruppe, bestehend aus einem eindimensionalen räumlich kodierten Fourier-Domain optischen Kohärenztomographie (1D-se FDOCT) Verfahren, einem eindimensionalen zeitlich kodiertem Fourier-Domain optischen Kohärenztomographie (1D-te FDOCT) Verfahren und einem eindimensionalen räumlich kodierten Time-Domain optischen Kohärenztomographie (1D-se TDOCT) Verfahren, ausgebildet ist, und
- **dass** die Steuereinheit (11) einen Regler aufweist, der zum Regeln einer Menge der von dem Spender (7) abzugebenden Ätzflüssigkeit (8) in Abhängigkeit von der Dicke (d_{f}(t)) des aufgebrachten Ätzfilms (22) aus Ätzflüssigkeit (8) und in Abhängigkeit von der Dickenabnahme (Δd(t)) des Halbleiterwafers (4) ausgebildet ist.

2. Dünnungsvorrichtung nach Anspruch 1,
**dadurch gekennzeichnet, dass**
das Spektrometer (17) ein optisches Gitter aufweist, wobei das optische Gitter zum Auffächern der spektralen Verteilung der reflektierten Strahlung (16) ausgebildet ist.

3. Dünnungsvorrichtung nach einem der vorhergehenden Ansprüche,
**dadurch gekennzeichnet, dass**
die Auswerteeinheit zusätzlich zum Ermitteln einer Dicke (d_{f}(t)) und Gleichmäßigkeit eines Ätzfilms (22) aus Ätzflüssigkeit (8) ausgebildet ist.

4. Dünnungsvorrichtung nach einem der vorhergehenden Ansprüche,
**dadurch gekennzeichnet, dass**
der Strahlteiler ein optischer Koppler (27) ist.

5. Dünnungsvorrichtung nach Anspruch 4,
**dadurch gekennzeichnet, dass**
zumindest ein erster Lichtwellenleiter (24) den Messkopf (13) mit dem optischen Koppler (27) verbindet und zumindest ein zweiter Lichtwellenleiter (26) den optischen Koppler (27) mit der Lichtquelle (14) verbindet und zumindest ein dritter Lichtwellenleiter (25) den optischen Koppler (27) mit dem Spektrometer (17) verbindet.

6. Dünnungsvorrichtung nach Anspruch 5,
**dadurch gekennzeichnet, dass**
der Spender (7) eine Tropfdüse oder eine Sprühdüse aufweist.

7. Verfahren zum Überwachen eines Dünnens mindestens eines optisch transparenten Halbleiterwafers (4) in einer Nassätzeinrichtung (5), wobei die Nassätzeinrichtung (5) mindestens eine drehbare Haltevorrichtung (6) aufweist, wobei das Verfahren folgende Verfahrensschritte aufweist:
- Fixieren mindestens eines Halbleiterwafers (4) auf der drehbaren Haltevorrichtung (6),
- Start eines Messvorgangs unter Aktivieren einer Lichtquelle (14) und Emittieren kohärenten Lichts eines Lichtwellenbandes, für das der Halbleiterwafer transparent ist, wobei ein Messkopf (13) den rotierenden Halbleiterwafer (4) mit dem kohärenten Licht des Lichtwellenbandes bestrahlt und reflektierte Strahlung (16) empfängt, und unter Aktivieren eines Spektrometers (17), das die reflektierte Strahlung (16) empfängt,
- Start eines Ätzvorgangs zur Dünnung des rotierenden Halbleiterwafers (4) unter Aufbringen einer Ätzflüssigkeit (8) mittels eines Spenders (7),
- Eingeben einer Enddicke (d_{z}) des zu dünnenden Halbleiterwafers (4) in eine Kopplungseinheit (20), die mit der Auswerteeinheit (18) der Überwachungsvorrichtung und einer Steuereinheit (11) der Nassätzeinrichtung (5) verbunden ist, und
- Stoppen des Ätzvorgangs beim Erreichen der vorgegebenen Enddicke (d_{z}) für den gedünnten Halbleiterwafer (4),
**gekennzeichnet durch**
- Auswerten der spektrometrisch aufgefächerten reflektierten Strahlung (16) zum Ermitteln einer erreichten Dicke d(t) des Halbleiterwafers (4) während des Dünnens des Halbleiterwafers (4) und der Dicke (d_{f}(t)) eines aufgebrachten Ätzfilms (22) aus Ätzflüssigkeit (8) mittels eines Verfahrens, ausgewählt aus der Gruppe, bestehend aus einem eindimensionalen räumlich kodierten Fourier-Domain optischen Kohärenztomographie (1D-se FDOCT) Verfahren, einem eindimensionalen zeitlich kodiertem Fourier-Domain optischen Kohärenztomographie (1D-te FDOCT) Verfahren und einem eindimensionalen räumlich kodierten Time-Domain optischen Kohärenztomographie (1D-se TDOCT) Verfahren, und
- Regeln einer Menge der pro Zeiteinheit der vom Spender (7) abzugebenden Ätzflüssigkeit (8) in Abhängigkeit von einer ermittelten erreichten Dicke (d_{f}(t)) des Ätzfilms (22) und in Abhängigkeit von einer Dickenabnahme (Δd(t)) des Halbleiterwafers (4).

8. Verfahren nach Anspruch 7,
**dadurch gekennzeichnet, dass**
das Fixieren des Halbleiterwafers (4) auf der drehbaren Haltevorrichtung (6) mittels eines Substrats (32) und einer Klebstoffschicht (53) erfolgt.

9. Verfahren nach Anspruch 8,
**dadurch gekennzeichnet, dass**
der zu dünnende Halbleiterwafer (4) zunächst auf das Substrat (32) aufgeklebt wird und das Substrat (32) mittels Vakuum oder mittels eines Permanentmagneten auf der drehbaren Halbleitervorrichtung (6) fixiert wird.

10. Verfahren nach Anspruch 7,
**dadurch gekennzeichnet, dass**
das Fixieren des Halbleiterwafers (4) auf der drehbaren Haltevorrichtung (6) mittels Vakuum erfolgt.

11. Verfahren nach einem der Ansprüche 7 bis 10,
**dadurch gekennzeichnet, dass**
zusätzlich zu der Erfassung der Dicke (d(t)) des zu dünnenden Halbleiterwafers (4) und der Dicke (d_{f}(t)) des Ätzfilms aus Ätzflüssigkeit die Gleichmäßigkeit des Ätzfilms (22) aus Ätzflüssigkeit (8) erfasst wird und zusätzlich zur Regelung der Menge von pro Zeiteinheit vom Spender (7) abzugebenden Ätzflüssigkeit, (8) in Abhängigkeit von der ermittelten erreichten Dicke (d_{f}(t)) des Ätzfilms (22) die Drehzahl (n) der Haltervorrichtung (6) in Abhängigkeit der Dickenmessung des Ätzfilms (22) geregelt wird.

12. Verfahren nach einem der Ansprüche 7 bis 11,
**dadurch gekennzeichnet, dass**
die Menge und/oder die Zusammensetzung der Ätzflüssigkeit (8) in Abhängigkeit der Dickenabnahme (Δd(t)) des Halbleiterwafers (4) kontinuierlich während des Ätzens geregelt wird.

13. Verfahren nach einem der Ansprüche 7 bis 12,
**dadurch gekennzeichnet, dass**
die Wellenlängen (λ) der reflektierten Strahlung (16) invertiert und dem Spektrometer (17) zugeführt werden.

## Claims

1. Thinning device with a wet etching apparatus (5) and a monitoring device (12) for monitoring a thinning of at least one semiconductor wafer (4) in the wet etching apparatus (5), the monitoring device (12) comprising the following:
- a light source (14) designed for emitting coherent light of a light wave band for which the semiconductor wafer (4) is optically transparent,
- a measuring head (13) arranged without contacting a surface to be etched of the semiconductor wafer (4), the measuring head (13) being designed for irradiating the semiconductor wafer (4) with the coherent light of the light wave band and for receiving a radiation (16) reflected by the semiconductor wafer (4),
- a spectrometer (17),
- a beam splitter via which the coherent light of the light wave band is directed onto the measuring head (13) and the reflected radiation is directed onto the spectrometer (17), and
- an evaluation unit (18),
wherein the thinning device comprises a coupling unit (20), a control unit (11) of the wet etching apparatus (5) and a dispenser (7) for an etching fluid for thinning the semiconductor wafer (4), wherein the coupling unit (20) is connected to the evaluation unit (18) and to the control unit (11) and is designed to stop the etching process on reaching a preset final thickness (d_{z}) of the thinned semiconductor wafer (4),
**characterised in that**
- the evaluation unit (18) is designed to determine a thickness d(t) of the semiconductor wafer (4) and the thickness (d_{f}(t)) of an applied etching film (22) of etching fluid (8) from the radiation (16) reflected by the semiconductor wafer (4) during the thinning of the semiconductor wafer (4), using a method selected from the group consisting of a one-dimensional spatially coded Fourier-Domain optical coherence tomography (1D-se FDOCT) method, a one-dimensional time-coded Fourier-Domain optical coherence tomography (1D-te FDOCT) method and a one-dimensional spatially coded Time-Domain optical coherence tomography (1D-se TDOCT) method, and **in that**
- the control unit (11) comprises a regulator designed to regulate a quantity of the etching fluid (8) to be dispensed by the dispenser (7) as a function of the thickness (d_{f}(t)) of the applied etching film (22) of etching fluid (8) and as a function of the thickness reduction (Δd(t)) of the semiconductor wafer (4).

2. Thinning device according to claim 1,
**characterised in that**
the spectrometer (17) has an optical grid, the optical grid being designed to fan out the spectral distribution of the reflected radiation (16).

3. Thinning device according to any of the preceding claims,
**characterised in that**
the evaluation unit (18) is additionally designed to determine a thickness (d_{f}(t)) and an evenness of an etching film (22) of etching fluid (8).

4. Thinning device according to any of the preceding claims,
**characterised in that**
the beam splitter is an optical coupler (27).

5. Thinning device according to claim 4,
**characterised in that**
at least one first optical waveguide (24) connects the measuring head (13) to the optical coupler (27) and at least one second optical waveguide (26) connects the optical coupler (27) to the light source (14) and at least one third optical waveguide (25) connects the optical coupler (27) to the spectrometer (17).

6. Thinning device according to claim 5,
**characterised in that**
the dispenser (7) has a drip nozzle or a spray nozzle.

7. Method for monitoring a thinning of at least one optically transparent semiconductor wafer (4) in a wet etching apparatus (5), the wet etching apparatus (5) comprising at least one rotatable holding device (6), the method comprising the following steps:
- the securing of at least one semiconductor wafer (4) on the rotatable holding device (6),
- the starting of a measuring process by activating a light source (14) and emitting coherent light of a light wave band for which the semiconductor wafer is optically transparent, wherein a measuring head (13) irradiates the rotating semiconductor wafer (4) with the coherent light of the light wave band and receives reflected radiation (16), and by activating a spectrometer (17) which receives the reflected radiation (16),
- the starting of an etching process for thinning the rotating semiconductor wafer (4) while applying an etching fluid (8) by means of a dispenser (7),
- the inputting of a final thickness (d_{z}) of the semiconductor wafer (4) to be thinned into a coupling unit (20) connected to the evaluation unit (18) of the monitoring device and to a control unit (11) of the wet etching apparatus (5), and
- the stopping of the etching process on reaching the preset final thickness (d_{z}) for the thinned semiconductor wafer (4),
**characterised by**
- the evaluation of the spectrometrically fanned-out reflected radiation (16) to determine an obtained thickness d(t) of the semiconductor wafer (4) during the thinning of the semiconductor wafer (4) and the thickness (d_{f}(t)) of an applied etching film (22) of etching fluid (8) using of a method selected from the group consisting of a one-dimensional spatially coded Fourier-Domain optical coherence tomography (1D-se FDOCT) method, a one-dimensional time-coded Fourier-Domain optical coherence tomography (1D-te FDOCT) method and a one-dimensional spatially coded Time-Domain optical coherence tomography (1D-se TDOCT) method, and
- the regulation of a quantity of etching fluid (8) to be dispensed by the dispenser (7) per unit of time as a function of the determined obtained thickness (d_{f}(t)) of the applied etching film (22) and as a function of a thickness reduction (Δd(t)) of the semiconductor wafer (4).

8. Method according to claim 7,
**characterised in that**
the semiconductor wafer (4) is secured on the rotatable holding device (6) by means of a substrate (32) and an adhesive layer (53).

9. Method according to claim 8,
**characterised in that**
the semiconductor wafer (4) to be thinned is first bonded to the substrate (32) and the substrate (32) is secured on the rotatable holding device (6) by means of a vacuum or a permanent magnet.

10. Method according to claim 7,
**characterised in that**
the semiconductor wafer (4) is secured on the rotatable holding device (6) by means of a vacuum.

11. Method according to any of claims 7 to 10,
**characterised in that**
in addition to the detection of the thickness (d(t)) of the semiconductor wafer (4) to be thinned and the thickness (d_{f}(t)) of the etching film of etching fluid, the evenness of the etching film (22) of etching fluid (8) is detected and, in addition to the regulation of the quantity of etching fluid (8) to be dispensed by the dispenser (7) per unit of time as a function of the determined obtained thickness (d_{f}(t)) of the etching film (22), the rotational speed (n) of the holding device (6) is regulated as a function of the thickness measurement of the etching film (22).

12. Method according to any of claims 7 to 11,
**characterised in that**
the quantity and/or the composition of the etching fluid (8) is continuously regulated as a function of the thickness reduction (Δd(t)) of the semiconductor wafer (4) during the etching process.

13. Method according to any of claims 7 to 12,
**characterised in that**
the wavelengths (λ) of the reflected radiation (16) are inverted and fed to the spectrometer (17).

## Revendications

1. Dispositif d'amincissement comprenant un dispositif de gravure humide (5) et un dispositif de surveillance (12) destiné à surveiller un amincissement d'au moins d'un semi-conducteur étagé (4) dans un dispositif de gravure humide (5), le dispositif de surveillance présentant les éléments suivants :
- une source lumineuse (14) conçue pour émettre une lumière cohérente d'une bande d'ondes optiques pour laquelle le semi-conducteur étagé (4) est optiquement transparent,
- une tête de mesure (13) sans contact disposée sur une surface à graver du semi-conducteur étagé (4), la tête de mesure (13) étant conçue pour exposer le semi-conducteur étagé (4) à la lumière cohérente de la bande d'onde optique et pour recevoir un rayonnement (16) réfléchi par le semi-conducteur étagé (4),
- un spectromètre (17),
- un séparateur de faisceau optique qui permet de diriger la lumière cohérente de la bande d'ondes optiques sur la tête de mesure (13) et le rayonnement réfléchi sur le spectromètre (17) et
une unité d'évaluation (18), le dispositif d'amincissement présentant une unité de couplage (20), une unité de commande (11), le dispositif de gravure humide (5) et un distributeur (7) pour le liquide de gravure pour amincir le semi-conducteur étagé (4), l'unité de couplage (20) étant reliée à l'unité d'évaluation (18) et à l'unité de commande et étant conçue pour arrêter le processus de gravure lorsqu'une épaisseur finale (dz) prédéfinie du semi-conducteur étagé aminci (4) est obtenue, **caractérisé en ce que**
- l'unité d'évaluation (18) est destinée à déterminer une épaisseur d(t) du semi-conducteur étagé (4) et l'épaisseur (d_{f}(t)) d'un film de gravure appliqué (22) à partir du liquide de gravure (8) provenant du rayonnement (16) réfléchi par le semi-conducteur étagé (4) pendant l'amincissement du semi-conducteur étagé (4) selon un procédé, sélectionné dans le groupe, constitué par un procédé de tomographie par cohérence optique en domaine de Fourier codé spatialement unidimensionnel (1 D-se FDOCT), un procédé de tomographie par cohérence optique en domaine de Fourier codé temporellement unidimensionnel (1 D-se-FDOCT) et un procédé de tomographie par cohérence optique en domaine temporel codé spatialement unidimensionnel (1 D-se TDOCT), et
- **en ce que** l'unité de commande (11) présente un régulateur qui est conçu pour réguler une quantité de liquide de gravure (8) à délivrer par le distributeur (7) en fonction de l'épaisseur (d_{f}(t)) du film de gravure appliqué (22) à partir du liquide de gravure (8) et en fonction de l'enlèvement d'épaisseur (Δd(t)) du semi-conducteur étagé (4).

2. Dispositif d'amincissement selon la revendication 1, **caractérisé en ce que** le spectromètre (17) présente une grille optique, la grille optique étant conçue pour répartir la répartition spectrale du rayonnement réfléchi (16).

3. Dispositif d'amincissement selon l'une quelconque des revendications précédentes, **caractérisé en ce que** l'unité d'évaluation est conçue en outre pour déterminer une épaisseur (d_{f}(t)) et l'uniformité d'un film de gravure (22) à partir du liquide de gravure (8).

4. Dispositif d'amincissement selon l'une quelconque des revendications précédentes, **caractérisé en ce que** le séparateur de faisceau est un coupleur optique (27).

5. Dispositif d'amincissement selon la revendication 4, **caractérisé en ce qu'**au moins un premier guide d'ondes optiques (24) relie la tête de mesure (13) au coupleur optique (27) et au moins un deuxième guide d'ondes optiques (26) relie le coupleur optique (27) à la source lumineuse (14) et au moins un troisième guide d'ondes optiques (25) relie le coupleur optique (27) au spectromètre (17).

6. Dispositif d'amincissement selon la revendication 5, **caractérisé en ce que** le distributeur (7) présente une buse goutte à goutte ou un pulvérisateur.

7. Procédé destiné à surveiller un amincissement d'au moins un semi-conducteur étagé (4) optiquement transparent dans un dispositif de gravure humide (5), le dispositif de gravure humide (5) présentant au moins un dispositif de retenue (6) tournant, le procédé présentant les étapes de procédé suivantes :
- fixer au moins le semi-conducteur étagé (4) sur le dispositif de retenue tournant (6),
- démarrer le processus de mesure par activation d'une source de lumière (14) et par émission de la lumière cohérente d'une bande d'ondes optiques, pour laquelle le semi-conducteur étage est transparent, une tête (13) de mesure exposant le semi-conducteur étagé (4) tournant à la lumière cohérence de la bande d'ondes optiques et recevant le rayonnement réfléchi (16) et par activation d'un spectromètre (17) qui reçoit le rayonnement réfléchi (16),
- démarrer un processus de gravure destiné à amincir le semi-conducteur étagé (4) tournant par application d'un liquide de gravure (8) au moyen d'un distributeur (7),
- entrer une épaisseur finale (dz) du semi-conducteur étagé (4) à amincir dans une unité de couplage (20) qui est reliée à l'unité d'évaluation (18) du dispositif de surveillance et à une unité de commande (11) du dispositif d'amincissement (5), et
- arrêter le processus de gravure lorsque l'épaisseur finale (d_{z}) prédéfinie pour le semi-conducteur étagé (4) aminci est obtenue,
**caractérisé par**
- l'évaluation du rayonnement (16) réfléchi réparti de manière spectrométrique destinée à déterminer une épaisseur obtenue d(t) du semi-conducteur étagé (4) pendant l'amincissement du semi-conducteur étagé (4) et de l'épaisseur (dt(t)) d'un film de gravure (22) appliqué à partir d'un liquide de gravure (8) selon un procédé sélectionné dans le groupe, constitué par un procédé de tomographie par cohérence optique en domaine de Fourier codé spatialement unidimensionnel (1D-se FDOCT), et un procédé de tomographie par cohérence optique en domaine de Fourier codé temporellement unidimensionnel (1D-se FDOCT), un procédé de tomographie par cohérence optique en domaine de Fourier codé temporellement unidimensionnel (1 D-te FDOCT) et un procédé de tomographie par cohérence optique en domaine temporel codé spatialement unidimensionnel, et
- la régulation d'une quantité du liquide de gravure (8) à distribuer par le distributeur (7) par unité de temps en fonction d'une épaisseur obtenue déterminée (d_{f}(t)) du film de gravure (22) et en fonction d'un enlèvement d'épaisseur (Δd(t)) du semi-conducteur étagé (4).

8. Procédé selon la revendication 7, **caractérisé en ce que** la fixation du semi-conducteur étagé (4) s'effectue sur le dispositif de retenue (6) tournant au moyen d'un substrat (32) et d'une couche d'adhésif (53).

9. Procédé selon la revendication 8, **caractérisé en ce que** le semi-conducteur étagé (4) à amincir est d'abord collé sur le substrat (32) et le substrat (32) est fixé au moyen de vide ou au moyen d'un aimant permanent sur le dispositif de retenue tournant (6).

10. Procédé selon la revendication 7, **caractérisé en ce que** la fixation du semi-conducteur étagé (4) s'effectue sur le dispositif de retenue (6) tournant au moyen de vide.

11. Procédé selon l'une quelconque des revendications 7 à 10, **caractérisé en ce qu'**en outre de la détermination de l'épaisseur (d(t)) du semi-conducteur étagé (4) à amincir et de l'épaisseur (d_{f}(t)) du film de gravure à partir du liquide de gravure l'uniformité du film de gravure (22) à partir du liquide de gravure (8) est déterminée et en outre de la régulation de la quantité de liquide de gravure à appliquer par le distributeur (7) par unité de temps en fonction de l'épaisseur (d_{f}(t)) obtenue déterminée du film de gravure (22) est régulée la vitesse (n) du dispositif de retenue (6) en fonction de la mesure de l'épaisseur du film de gravure (22).

12. Procédé selon l'une quelconque des revendications 7 à 11, **caractérisé en ce que** la quantité et/ou la composition du liquide de gravure (8) est régulée en fonction de l'enlèvement d'épaisseur (Δd(t)) du semi-conducteur étagé (4) en continu pendant la gravure.

13. Procédé selon l'une quelconque des revendications 7 à 12, **caractérisé en ce que** les longueurs d'ondes (λ) du rayonnement réfléchi (16) sont inversées et dirigées vers le spectromètre (17).
